# EUROPEAN PATENT SPECIFICATION

(11) **EP 0 376 620 B1**
(45) Date of publication and mention of the grant of the patent: **16.04.1997**
(21) Application number: 89313408.0
(22) Date of filing: 21.12.1989
(51) Int. Cl.: H01L 21/56, H01L 21/48, H01L 23/31

(54) **Method for processing plastic packaged electronic devices**
Verarbeitungsverfahren für mit Plastik umhüllte elektronische Anordnungen
Procédé pour le traitement de dispositifs électroniques encapsulés en plastique

(30) Priority: 27.12.1988 US 289858
(43) Date of publication of application: 04.07.1990
(73) Proprietor: NCR International, Inc., Dayton, Ohio 45479 (US)
(72) Inventor: Elliott, Blaine Keith, Columbia South Carolina 29201 (US)
(74) Representative: Robinson, Robert George

(56) References cited:
- US-A- 3 815 251
- US-A- 4 239 485
- US-A- 4 777 520
- IEEE 26th Annual Proceedings - Reliability Physics 1988 14 April 1988, Monterey, CA, US, pages 83 - 89; R.LIN ET AL.: "Moisture Induced Package Cracking in Plastic Encapsulated Surface Mount Copmponents During Solder Reflow Process"
- IEEE 26th Annual Proceedings - Reliability Physics 1988 14 April 1988, Monterey, CA, US, pages 90 - 95; M.KITANO ET AL.: "Analysis of Package Cracking During Reflow Soldering Process"
- Le Vide - Technique-Applications, 18e Année, No.106, July/August 1963 PARIS FR pages 363 - 373; , D.BAKER: "Etanchéité et dégazage dans les transistors encapsulés par soudage à froid et par soudage électrique"

## Description

This invention relates to a method for processing a plastic packaged electronic device prior to connecting the device by soldering to a printed circuit board. By a plastic packaged electronic device is meant an electronic device, such as a semiconductor chip, encapsulated in a plastic material, with external leads projecting from the encapsulating material.

The build-up of a printed circuit board for electronic and computer equipment entails the connection of electronic devices, sub-assemblies, and other such components to the board. A common means for building up printed circuit boards, sometimes referred to as "through-hole" technology, involves mounting components on one side of a board by inserting their leads through holes extending through the board. The components are affixed to the board by soldering the lead ends where they protrude from the back side of the board. A conventional soldering technique is "wave soldering" where a printed circuit board with loosely held components is passed over a bath of molten solder. The lead ends are soldered as they are contacted by a wave of the molten solder.

An emerging technology for the build up of printed circuit boards is referred to as surface mount technology, and involves the mounting of components on both sides of a printed circuit board. Surface mount technology has one obvious advantage over through-hole technology in the greater number of components that can be mounted per board. However, the highly automated technique of wave soldering is unusable. Individual components may be mounted to the board surface by hand soldering. This is both time consuming and expensive. A preferred process for mass soldering in surface mount technology involves heating the board and components. Both hot air and infrared (IR) radiation are used for such heating. For example, an IR reflow oven heats the various components, using infrared radiation, until the solder melts (about 218°C).

The relatively high temperature of the IR reflow oven presents some problems. Many of the electronic devices to be mounted on the board are plastic packaged electronic devices. Plastic packaged electronic devices may be formed by encapsulating semiconductor chips in an epoxy resin in order to provide support for the chips and to protect them from the environment. These plastic packaged devices typically have a plurality of thin, gold bonding wires, having a thickness of the order of 0.025 millimetre, which are bonded at one end to contact regions on the chip. The other ends of the gold wires are bonded to larger gauge metal leads which are the contact leads or pins which provide the physical connections to the board. The chip, the gold wires and parts of the metal leads are encapsulated by the epoxy resin with only the external parts of the leads extending from the device. The encapsulating plastic material has the property of absorbing moisture when subjected to a humid environment. When subjected to the high temperature of an IR reflow oven, any moisture in the plastic is rapidly vaporized. The vapour expansion may create small cracks which propagate through the plastic. These cracks appear as cosmetic flaws in the chip which can create later problems as water enters the crack, penetrates to the chip and corrodes the contacts. The cracks can also create a more immediate problem by breaking the thin bonding wires. This cracking problem is particularly acute in larger devices such as relatively high pin count chips. Sometimes the chip itself may have microscopic cracks in it caused by excessive pressure applied between the chip contact and bonding wires during manufacture (known as overbonding). These microscopic cracks may cause no harm. However, moisture may collect in the cracks and when rapidly vaporized during soldering crack the chip itself (known as chip-out).

US-A-4777520 discloses examples of plastic packaged electronic devices. This patent discloses a plastic packaged semiconductor chip device in which the cracking problem referred to above is overcome, this device incorporating a special internal mounting arrangement together with a vent in the encapsulating material to permit water vapour to be vented out through the vent when the device is heated at a soldering temperature. This known device has the disadvantage of being of complex construction, particularly since it is necessary to coat the chip with a silicone resin to protect the chip from moisture and impurities entering through the vent.

Another method of avoiding the cracking problem is to bake a plastic packaged electronic device at a lower temperature (about 125°C for 24 hours) prior to carrying out the soldering operation in an IR reflow oven. This allows the moisture to be vaporized more slowly permitting the vapour to be released from the plastic without cracking the device. Several problems exist with this baking process. First, the external leads of an electronic device are normally dipped or coated with a tin/lead solder. The solder will not melt below about 183°C; however, heating the solder at a temperature of 125°C renders the solder liable to oxidation. Since oxidized leads render chips unusable, once a device is baked to drive off absorbed moisture it must be protected from further humidity until processed in the IR reflow oven. Devices that are not to be mounted for IR reflow oven processing within 96 hours are normally sealed in vapour tight bags with desiccant. The cost of preventing the devices from re-absorbing moisture after being baked is undesirable. Pages 90-95 of the IEEE 26th Annual Proceedings - Reliability Physics 1988, 14 April 1988, describe the heating of an electronic device by a two-stage process that involves heating the device at a low and then high temperature. However, this two-stage process is carried out simply for studying the effects of moisture in the device without any consideration for limiting the temperature during a moisture drive-off stage.

Pages 83-89 of the aforementioned reference describes the problem of moisture induced package cracking in plastic encapsulated surface mounted components during a solder reflow process. A model of diffusion and a method of acoustic microscopy inspection of package cracking is disclosed. However, no methods of processing the packages in order to drive off moisture are presented.

Also, US-A-4239 485 discloses apparatus for passing products through a "processing station" for heating, cooling, coating or chemically treating the products as required. No mention is made of a requirement or method, for controlling the heating temperature by variation of pressure or otherwise.

Another problem with the baking process involves various types of protective carriers used to transport and store electronic devices. For example, plastic tubes are used to prevent mechanical damage to the device leads, various static shielding containers are used to prevent electrical damage to the devices, and tape and reel configurations separate and orient smaller devices for automated assembly. In most cases, removing the devices from their carriers for the baking process defeats the purpose of the carrier, e.g., leads may be bent, chips may be destroyed by electrostatic charges and the organization of taped components may be lost. However, in most cases 125°C exceeds the critical temperature at which the carrier structure degrades, i.e., the temperature at which plastic tubes, static shields and plastic carrier tape melt or otherwise deteriorate. Thus, in order to bake devices to drive off moisture, they must be removed from their protective carriers which inevitably leads to additional part losses and other expenses. Known processing techniques, such as described above, have in the past resulted in losses as high as 42% for high pin-count devices.

It is an object of the invention to provide a method for reducing heat-induced cracking of a plastic packages electronic device, which is realised by the method according to claim 1.

The present invention is based on the discovery that, by heating a plastic packaged electronic device in a reduced pressure environment, moisture absorbed by the encapsulating material can be driven off at a relatively low temperature compared with prior art processing methods, whereby oxidation of soldered leads of the device may be avoided, and whereby the device may be heated together with a carrier without any degradation of the carrier. Preferably, where the device has soldered leads the device is heated in a reduced pressure environment at a temperature of not greater than about 60°C.

A method in accordance with the invention will now be described by way of example with reference to plastic packaged semiconductor chips which are carried by a carrier for the purpose of transportation and/or storage.

The pins of the semiconductor chip devices are well supported, and they can be worked without undue concern of disconnecting them from the chips. However, this is not to say that the pins can be bent with impunity. The process of encapsulating chips in an epoxy resin results in careful alignment of the contact pins. Particularly with high pin count devices this alignment is critical to ensure accurate positioning with respect to bonding contacts on a printed circuit board. To avoid misalignment, the pins must be handled as little as possible from the time the devices are fabricated until installed on a circuit board. A number of devices can be so protected during transportation by inserting them into a plastic tube. A typical tube can be closed at both ends to keep the devices front falling out. For relatively low pin count devices, particularly those which are going to be automatically positioned on to a circuit board by machine, a tape and reel carrier may be more practical. A tape and reel carrier consists of a relatively long strip of plastic tape with adhesive at regular intervals along the tape where the plastic bodies of the devices are affixed. The tape and attached devices are rolled up on to a reel which can be later mounted on to a machine for automatically removing the devices and positioning them on to a printed circuit board. Although tape and reel carriers protect leads from being bent, an equally important function is to provide a means for efficient automatic handling of the device.

Each of the previously described carriers has a critical temperature at which its structure degrades. For plastic tubes and tapes the critical temperature is the temperature at which the plastic starts to melt, between 55°C and 70°C. The critical temperature for both types of carriers is much less than the melting point temperature of the encapsulating material and also less than the 125°C used in the previously described prior art method to drive moisture out of plastic packaged devices.

Solder of course melts when it reaches a certain temperature, typically 183°C. Oxidation is a problem because the solder paste used to join the device to the printed circuit board must wick up the device leads. Wicking does not occur if the solder is oxidized. It is found that solder becomes liable to oxidation if heated above a critical temperature of about 60°C. The critical temperature for solder is less than the melting point temperature of the encapsulating material, and also less than the 125°C previously used to drive moisture out of plastic packaged devices.

In the method of the present invention, the devices together with their carrier are baked to controllably drive off moisture absorbed by the plastic packages. The devices and carrier are placed in an oven. If the devices are inside a plastic tube, the cover at one end of the tube is first removed so that water vapour will be able to escape. There is no need to remove the devices from the carrier, thereby reducing the risk of accidental damage to the pins. The oven is depressurized to considerably less than atmospheric pressure. Preferably the pressure is reduced to less than 4.67 kPa (35 torr), and in a preferred embodiment the pressure within the oven is reduced to about 4.00 kPa (30 torr). The devices are then heated by raising the temperature within the oven, so as to drive off moisture from the encapsulating plastic material. The oven temperature is less than the critical temperature of solder and the critical temperature of the carrier, but high enough to drive off moisture previously absorbed by the encapsulating material. Preferably the device will be heated by raising the temperature within the oven to between 35°C and 40°C, and in a preferred embodiment to about 35°C. At 4kPa (30 torr and 35°C, a device is baked about 12 to 24 hours to reduce the moisture content to an acceptable level.
Generally this is about .013% of the device or package weight.

After a device has been processed as described above, it can be subjected to the much higher heat of an IR reflow oven for soldering to a printed circuit board, with virtually no risk of heat-induced cracking. If the device is not used within a predetermined length of time, normally 96 hours if not sealed with a desiccant, it can be rebaked without solder oxidation or other damage.

It has been found that a pre-soldering processing method in accordance with the invention reduces device processing losses from as high as 42% with prior art methods to virtually zero.

## Claims

1. A method of processing a plastic packaged electronic device prior to connecting said plastic packaged electronic device by soldering to a printed circuit board, wherein said plastic packaged electronic device is carried by a plastic carrier which has a critical temperature at which its structure degrades, said critical temperature being less than the melting point of the plastic encapsulating material of said plastic packaged electronic device and is not more than 70°C, and by the steps of placing said plastic packaged electronic device and said plastic carrier in an oven, reducing the pressure in said oven to less than atmospheric pressure, and heating said device and said plastic carrier so as to drive off moisture absorbed by said plastic encapsulating material, the temperature at which said moisture is driven off being maintained at less than said critical temperature of said plastic carrier.

2. A method according to claim 1, wherein said plastic packaged electronic device has leads coated with solder for connection to said printed circuit board, and in that the step of heating said plastic packaged electronic device and said plastic carrier involves heating said plastic packaged electronic device and said plastic carrier at a temperature of not more than 60°C.

3. A method according to claim 2, wherein said plastic carrier is in the form of a plastic tube in which said plastic packaged electronic device is mounted.

4. A method according to claim 2, wherein said plastic carrier is in the form of a plastic tape to which said plastic packaged electronic device is affixed.

5. A method according to any one of the preceding claims, wherein the step of heating said plastic packaged electronic device and said plastic carrier involves heating said plastic packaged electronic device and said plastic carrier at a temperature in the range 30°C to 35°C.

6. A method according to any one of the preceding claims, wherein the pressure in said oven is reduced to less than 4.67 kPa (35 torr).

7. A method according to claim 6, wherein said pressure is about 4.00 k Pa (30 torr).

8. A method according to any one of the preceding claims, wherein the step of heating said plastic packaged electronic device and said plastic carrier is carried on for between 12 and 24 hours.

## Patentansprüche

1. Verfahren zur Verarbeitung einer kunststoffumhüllten elektronischen Anordnung vor Verbinden der kunststoffumhüllten elektronischen Anordnung mittels Löten mit einer gedruckten Leiterplatte, wobei die kunststoffumhüllte elektronische Anordnung durch einen Kunststoffträger gehalten ist, der eine kritische Temperatur aufweist, bei der sich seine Struktur zersetzt, wobei diese kritische Temperatur niedriger ist als der Schmelzpunkt des Kunststoffkapselmaterials der kunststoffumhüllten elektronischen Anordnung und nicht mehr als 70°C beträgt, und durch die Schritte Plazieren der kunststoffumhüllten elektronischen Anordnung und des Kunststoffträgers in einem Ofen, Senken des Drucks in dem Ofen auf weniger als den Atmosphärendruck, und Erwärmen der Anordnung und des Kunststoffträgers, um von dem Kunststoffkapselmaterial aufgenommene Feuchtigkeit auszutreiben, wobei die Temperatur, bei der die Feuchtigkeit ausgetrieben wird, unter der kritischen Temperatur des Kunststoffträgers gehalten wird.

2. Verfahren nach Anspruch 1, wobei die kunststoffumhüllte elektronische Anordnung mit Lötmittel beschichtete Anschlüsse zur Verbindung mit der gedruckten Leiterplatte aufweist, und der Schritt Erwärmen der kunststoffumhüllten elektronischen Anordnung und des Kunststoffträgers das Erwärmen der kunststoffumhüllten Anordnung und des Kunststoffträgers bei einer Temperatur von nicht über 60°C einschließt.

3. Verfahren nach Anspruch 2, wobei der Kunststoffträger in Form eines Kunststoffschlauchrohrs ausgebildet ist, in dem die kunststoffumhüllte elektronische Anordnung befestigt ist.

4. Verfahren nach Anspruch 2, wobei der Kunststoffträger in Form eines Kunststoffbandes ausgebildet ist, an dem die kunststoffumhüllte elektronische Anordnung befestigt ist.

5. Verfahren nach einem der vorhergehenden Ansprüche, wobei der Schritt Erwärmen der kunststoffumhüllten elektronischen Anordnung und des Kunststoffträgers das Erwärmen der kunststoffumhüllten elektronischen Anordnung und des Kunststoffträgers bei einer Temperatur im Bereich von 30°C bis 35°C einschließt.

6. Verfahren nach einem der vorhergehenden Ansprüche, wobei der Druck in dem Ofen auf unter 4,67 kPa (35 Torr) gesenkt wird.

7. Verfahren nach Anspruch 6, wobei der Druck ca. 4,00 kPa (30 Torr) beträgt.

8. Verfahren nach einem der vorhergehenden Ansprüche, wobei der Schritt Erwärmen der kunststoffumhüllten elektronischen Anordnung und des Kunststoffträgers 12 bis 24 Stunden lang fortgeführt wird.

## Revendications

1. Une méthode pour traiter un dispositif électronique à boîtier en matière plastique avant de connecter ledit dispositif électronique à boîtier en matière plastique en soudant à une carte équipée, dans laquelle ledit dispositif électronique à boîtier en matière plastique est supporté par un support en matière plastique qui a une température critique à laquelle sa structure se dégrade, ladite température critique étant inférieure au point de fusion de la matière plastique d'enrobage dudit dispositif électronique à boîtier en matière plastique et pas supérieure à 70ºC, et par les étapes du placement dudit dispositif électronique à boîtier en matière plastique et dudit support en matière plastique dans un four, de la réduction de la pression dans ledit four à une pression inférieure à la pression atmosphérique, et du chauffage dudit dispositif électronique à boîtier en matière plastique et dudit support en matière plastique de façon à éliminer l'humidité absorbée par ladite matière plastique d'enrobage, la température à laquelle ladite humidité est éliminée étant maintenue à une température inférieure à ladite température critique dudit support en matière plastique.

2. Une méthode conformément à la revendication 1, dans laquelle ledit dispositif électronique à boîtier en matière plastique a des fils enduits de métal à souder pour la connexion à ladite carte équipée, et dans laquelle l'étape du chauffage dudit dispositif électronique à boîtier en matière plastique et dudit support en matière plastique comporte le chauffage dudit dispositif électronique à boîtier en matière plastique et dudit support en matière plastique à une température pas supérieure à 60ºC.

3. Une méthode conformément à la revendication 2, dans laquelle ledit support en matière plastique se présente sous la forme d'un tube en matière plastique dans lequel est monté ledit dispositif électronique à boîtier en matière plastique.

4. Une méthode conformément à la revendication 2, dans laquelle ledit support en matière plastique se présente sous la forme d'un ruban en matière plastique auquel est apposé ledit dispositif électronique à boîtier en matière plastique.

5. Une méthode conformément à l'une quelconque des revendications précédentes, dans laquelle l'étape du chauffage dudit dispositif électronique à boîtier en matière plastique et dudit support en matière plastique comporte le chauffage dudit dispositif électronique à boîtier en matière plastique et dudit support en matière plastique à une température dans la plage de 30ºC à 35ºC.

6. Une méthode conformément à l'une quelconque des revendications précédentes, dans laquelle la pression dans ledit four est réduite à moins de 4,67 kPa (35 torr).

7. Une méthode conformément à la revendication 6, dans laquelle ladite pression est d'environ 4,00 kPa (30 torr).

8. Une méthode conformément à l'une quelconque des revendications précédentes, dans laquelle l'étape du chauffage dudit dispositif électronique à boîtier en matière plastique et dudit support en matière plastique est effectuée pendant entre 12 et 24 heures.
